# EUROPEAN PATENT SPECIFICATION

(11) **EP 2 827 687 B1**
(45) Date of publication and mention of the grant of the patent: **13.03.2019**
(21) Application number: 14176340.9
(22) Date of filing: 09.07.2014
(51) Int. Cl.: H05K 1/02, F21K 9/00, H05K 3/00, F21Y 115/10

(54) **A method of producing a support structure for lightning devices**
Verfahren zur Herstellung einer Stützstruktur für Beleuchtungsvorrichtungen
Procédé de fabrication d'une structure de support pour dispositifs d'éclairage

(30) Priority: 15.07.2013 IT TO20130592
(43) Date of publication of application: 21.01.2015
(73) Proprietor: OSRAM GmbH, 80807 München (DE); OSRAM S.P.A. - SOCIETA' RIUNITE OSRAM EDISON CLERICI, 20126 Milano (IT)
(72) Inventor: Cacchione, Fabrizio, I-30031 Dolo (Venezia) (IT); Sagliocco, Alessio, I-30027 San Donà di Piave (Venezia) (IT)
(74) Representative: Bosotti, Luciano

(56) References cited:
- EP-A1- 2 312 204
- EP-A1- 2 432 038
- EP-A2- 1 469 707
- WO-A1-2009/135997
- US-A1- 2007 121 326
- US-A1- 2009 277 684
- US-A1- 2011 095 690

## Description

### Technical Field

This description refers to lighting techniques.

One or more embodiments may relate to support structures for lighting devices, for example for lighting devices employing solid-state sources such as LED sources as light radiation sources.

### Technological background

Various implementations of lighting devices involve the use of supporting structures including a circuit board (substantially similar to a Printed Circuit Board or PCB) associated with a heat sink.

Several ways to connect such a circuit board to a heat sink are known.

Several of these implementations may provide, for example, for the use of screws, springs, bayonet or snap couplings.

These various implementations may have both advantages and limitations to be evaluated on a case by case basis.

A common factor lies in that, in view of geometric tolerances, assembly tolerances and the nature of the contact surfaces, the heat exchange between the circuit board and the heat sink may be negatively affected. To remedy this, recourse may be had to thermal interface materials.

From document EP 2 466 198 A1 there is known a heat sink made of a plastic material that is thermally conductive and electrically insulating.

Document DE 102 47 828 A1 discloses a plastic material housing with the capability of dissipating and radiating heat.

Document US 2006/0255451 A1 discloses the possibility of making a thermal interface material more or less thermally conductive through the addition of different materials.

Document WO 2012/091364 discloses a LED lighting device including a heat-dissipating housing which is injection moulded using a thermally conductive and electrically insulating synthetic resin. An electrically conductive lighting source mounting portion of a linear shape is injection moulded on the top surface of the housing. Electrical circuits can be provided by printing electrically conductive ink. The circuit portions are carried by a plate which extends through the internal cavity of the heat-dissipating housing at a distance from the wall thereof.

Document US 2007/0121326 A1 discloses the possibility of overmoulding a high thermal conductivity material on the back of a printed circuit board.

Document US 2011/0095690 A1 discloses the possibility of overmoulding a heat sink housing of a thermally conductive material on a circuit board.

Documents such as EP 1 469 707 A2, WO 2009/135997 A1, EP 2 312 204 A1, EP 2 432 038 A1, and US 2009/277684 A1 are of general interest for one or more embodiments.

### Object and Summary

The object of one or more embodiments is to overcome the drawbacks of such implementations.

According to one or more embodiments, this object is achieved thanks to a method having the characteristics claimed in claim 1.

The claims are an integral portion of the disclosure provided herein in relation with embodiments.

One or more embodiments may provide one or more of the following advantages:
- no thermal interfaces exist between the heat sink and the circuit board,
- the possibility exists of producing, for example in the case of co-moulding, a chemical bond between two different polymers by ensuring that the portions (the circuit board and heat sink) are microscopically welded to one another;
- in the case of over-moulding, it is possible to provide for the presence of pins or other mechanical coupling formations aimed at generating a compressive force from the circuit board to the heat sink, with the possibility of providing and adhesion of the chemical type, for example using additives suited to ensure the "grip" between different materials;
- coupling the circuit board and the heat sink requires no additional assembly processes.

### Brief description of the figures

One or more embodiments will now be described, purely by way of non-limiting example, with reference to the annexed figures, wherein:
- Figure 1, including three portions indicated with a), b), c), respectively, illustrates a method of realizing embodiments,
- Figure 2, including four portions indicated with a), b), c) and d), illustrates various steps of a method for realizing embodiments,
- Figure 3 is illustrative of embodiments,
- Figure 4 shows, reproduced in enlarged scale, the portion of Figure 3 indicated by the arrow IV, and
- Figures 5 and 6 show possible details of embodiments.

### Detailed description

In the following description, various specific details aimed at a thorough understanding of various exemplary embodiments are disclosed. One or more embodiments may be implemented without one or more of the specific details, or with other methods, components, materials, etc.. In other cases, known structures, materials, or operations are not shown or described in detail to avoid obscuring various aspects of the embodiments. Reference to "one or more embodiments" in the context of this description is to indicate that a particular configuration, structure or characteristic described in connection with the embodiment may be included in at least one embodiment. So, reference to "one embodiment", possibly present in various points of this description is not necessarily directed to the same embodiment. Furthermore, particular conformations, structures, or characteristics may be combined in any suitable manner in one or more embodiments.

The references used herein are only for the convenience of the reader and therefore do not define the extent of protection or the scope of the embodiments.

The present detailed description illustrates, purely by way of example, various embodiments of processes for creating an intimate connection of the thermal type between portions of a support structure 10 for lighting devices.

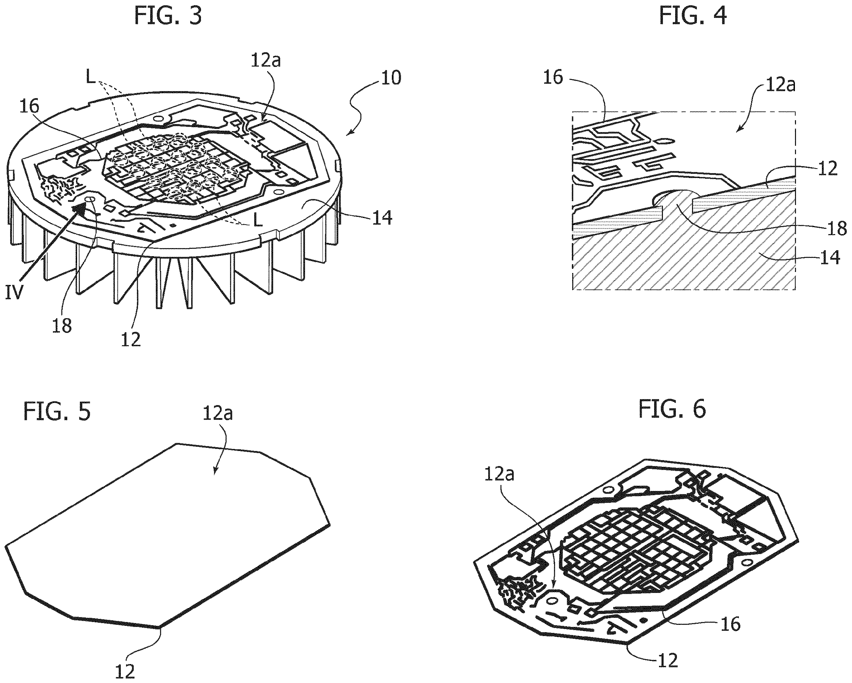

In one or more embodiments, one of the portions in question may be a circuit board 12 (substantially similar to a Printed Circuit Board or PCB, or a circuit that is printed on top of a plastics substrate which is thermally conductive and electrically insulating called Printed Circuit on Plastic or PCP), with at least a part on which it is possible to mount one or more light radiation sources, for example of the solid state type, such as LED sources L - schematically represented for simplicity only in Figure 3. In one or more embodiments, the board 12 may include a front surface 12a for mounting the light radiation source or sources.

In one or more embodiments, another portion of the structure 10 may be a heat sink 14 of thermally conductive plastics, such as a finned heat sink, adapted to be coupled to the circuit board 12 at the back face of the board 12 itself, or the portion 12 and the portion 14 may be the same material thus a single piece onto which an electronic circuit is printed.

In one or more embodiments, the circuit board 12, which can also be considered as a single body that is just the union of the portion 12 and the portion 14, may be provided, on its front face 12a with electrically conductive lines 16 permitting to electrically feed the light radiation source or sources L that are electrically powered light radiation sources.

In one or more embodiments, the heat sink 14 may include a thermally conductive or jointly thermally conductive and electrically insulating thermoplastic material such as a thermally conductive thermoplastic material of a known type.

In one or more embodiments, the circuit board 12 and the heat sink 14 are moulded together so as to be linked (bonded) together in the absence of interposed thermal interfaces, so that they may be considered as portions of a single element made of a same material. Independently of the specific implementation details, in one or more embodiments, the whole board 12, the board 12 plus the heat sink 14 as a single material or at least the part of the circuit board 12 designed to receive the light radiation source or sources L, are bonded with the heat sink 14 in the absence of thermal interfaces interposed, thus improving heat dissipation from the source or from the sources L.

The possible presence of thermal interfaces may be a feature of conventional implementations, such as to require the use of thermoconductive fatty substances or conductive materials capable of filling the interstices possibly formed between the circuit board and the heat sink in order to improve the heat transmission capability.

One or more embodiments may permit to dispense with these drawbacks due to the circuit board 12 and the heat sink 14 being jointly moulded together and/or being the same material. In one or more embodiments, the board 12 and the heat sink 14 may be bonded together by means of plastic injection moulding processes.

In one or more embodiments, the circuit board 12 may be a PCB board of the type with a metal core. In one or more embodiments, the circuit board 12 may include a substrate of thermally conductive and electrically insulating plastics material, with electrically conductive lines 16 provided thereon (for example, as further detailed in the following).

One or more embodiments may give rise to a strong coupling between the circuit board 12 and the heat sink 14.

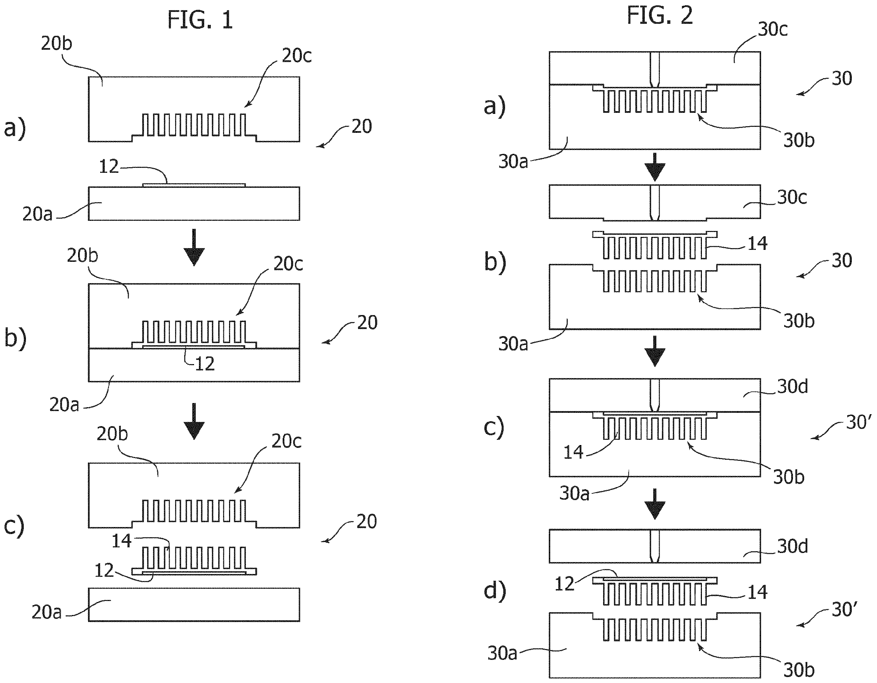

One or more embodiments may provide for different ways to achieve this coupling. One or more embodiments, as exemplified in Figure 1, may provide for the use of a heat sink 14 which is moulded onto the board 12.

For example, Figure 1 shows a circuit board 12 arranged in a mould 20 including two complementary portions (so-called "semi-moulds"), indicated with 20a and 20b, respectively. In the example of embodiment illustrated in Figure 1, which is just an example, the portion 20a is a support onto which the board 12 can be caused to rest, as schematically represented in portion a) of Figure 1.

The mould 20 can then be closed by overlapping onto the portion 20a with the board 12 resting on it the portion 20b that has a portion 20c provided with a sculpturing (i.e. a mould cavity proper) which reproduces in a complementary way the shape of the heat sink 14, e.g. of a finned portion thereof.

Once the mould 20 is closed, as schematically represented in portion b) of Figure 1, into the sculptured portion 20c there may be introduced (for example, according to the typical approach of an injection moulding process) a thermally conductive resin of any known type so to be produce by moulding the heat sink 14, which is thus "overmoulded" on the board 12 by achieving a firm bonding in the absence of thermal interfaces interposed.

In one or more embodiments as exemplified in Figure 2 one may provide for using a mould 30, 30' with more complementary portions.

For example, Figure 2 refers to a mould portion 30a having a sculpturing 30b which again reproduces in a complementary way the shape of the heat sink 14.

This can be thus be formed, as schematically represented by the sequence of figures of the portions a) and b) of Figure 2, again e.g. by injecting a thermally conductive resin into the sculptured portion 30b with the complementary portion 30c of the mould closed onto the portion 30a so as to allow, for example, performing an injection moulding process.

Once formed, as schematically shown in portion b) of Figure 2, the heat sink 14 can be inserted into a mould 30' in view of coupling with the board 12.

Figure 2 refers to an example in which the heat sink 14 is not extracted from the mould where it was formed, but (as exemplified by the indication of the portions 30a being maintained through the sequence of the portions of Figure 2) kept in its formation mould 30a. This is to receive, coupled thereon as schematically represented by the sequence of portions c) and d) of Figure 2, the circuit board 12.

As already indicated, in one or more embodiments, the board may include a PCB board with a metal core or include a substrate of thermally conductive and electrically insulating plastics material, thus adapted to be moulded on top of the heat sink 14 by using for instance a mould portion 30d.

To this end, in one or more embodiments, it is possible to use in this regard an injection moulding process.

In one or more embodiments, a sequence of coupling between the heat sink 14 and board 12 as exemplified in the sequence of portions c) and d) in Figure 2 lends itself to be implemented in connection with processes of the MID (Moulded Interconnect Device) type or plasma deposition processes.

Whatever the solution adopted for moulding together the board 12 and the heat sink 14, one or more embodiments allow to avoid the formation of thermal interfaces between the board 12 and the heat sink 14.

For example, in the case of overmoulding as exemplified in Figure 1, the connection between the board 12 and the heat sink 14 can be further strengthened by providing mechanical coupling formations such as pins 18 (see Figure 4) with the function of giving rise to a compressive force from the board 12 to the heat sink 14. This with the possibility of further promoting the chemical adhesion between the board 12 and the heat sink 14 with the use of additives such as to ensure the "grip" between the two materials constituting the board 12 and the heat sink 14.

For example, in the case of co-moulding as exemplified in Figure 2 it is possible to achieve a chemical bond between the board 12 and the heat sink 14, for example between two polymers (for example different from one another) which constitute the two elements 12 and 14 which can be so microscopically bonded to one another. In one or more embodiments, the electrically conductive lines 16 may be formed on the front face 12a of the board 12 by a printing process, for example by screen printing or by pad-printing.

In one or more embodiments, the electrically conductive lines 16 may include electrically conductive thermosetting or thermoplastic resins.

According to the invention, the electrically conductive lines 16 are formed on the board 12 after it has been coupled to the heat sink 14.

In one or more embodiments, the LEDs L can be soldered, glued or printed on the front face 12a of the board 12. Of course, without prejudice to underlying principle, the details of construction and the embodiments may vary, even significantly, with respect to what is here illustrated purely by way of non-limiting example, without thereby departing from the extent of protection. The extent of protection defined by the appended claims.

## Claims

1. A method of producing a support structure (10) for lighting devices,
the support structure including:
- a circuit board portion (12) with a front surface (12a) for mounting at least one electrically powered light radiation source (L), the circuit board portion (12) having electrically conductive lines (16) printed onto said front surface (12a) of the circuit board portion (12)for electrically powering said at least one light radiation source (L), and
- a heat sink portion (14) coupled to the back face of the circuit board portion (12) to dissipate heat produced by said at least one light radiation source (L), wherein:
- the heat sink portion (14) includes a thermally conductive thermoplastic material,
- the circuit board portion (12) and the heat sink portion (14) are moulded together and bonded in the absence of thermal interfaces therebetween by
- overmoulding the heat sink portion (14) onto the circuit board portion (12), or
- moulding the heat sink portion (14) and co-moulding the printed circuit board portion (12) with the heat sink portion (14),
and wherein
- the electrically conductive lines (16) are printed onto said front surface (12a) of the circuit board portion (12) after it has been coupled to the heat sink portion (14).

2. The method of claim 1, wherein the electrically conductive lines (16) are printed onto said front surface (12a) of the circuit board portion (12) by screen printing or pad printing.

3. The support structure of claim 1 or claim 2, wherein at least a part of the circuit board portion (12) for receiving said at least one electrically powered light radiation source (L) mounted thereon is bonded to the heat sink portion (14) in the absence of thermal interfaces therebetween.

4. The method of claim 1 or claim 2, wherein the whole of the circuit board portion (12) is bonded to the heat sink portion (14) in the absence of thermal interfaces therebetween.

5. The method of any of the previous claims, wherein the circuit board portion (12) is a metal core printed circuit board.

6. The method of any of the previous claims, wherein the circuit board portion (12) includes a thermally conductive plastic material.

7. The method of any of the previous claims, including mechanical formations (18) to produce a compression force from the circuit board portion (12) to the heat sink portion (14).

8. The method of any of the previous claims, wherein said circuit board portion (12) and said heat sink portion (14) include a same material.

9. The method of any of the previous claims, wherein said circuit board portion (12) and said heat sink portion (14) are one piece.

10. A method of any of the previous claim , including providing at least one electrically powered light radiation source (L) on said front surface (12a) of said circuit board portion (12) in electrical contact with said electrically conductive lines (16) to be electrically powered thereby.

11. The method of claim 10, comprising soldering, gluing or printing said at least one electrically powered light radiation source (L) on said front surface (12a) of said circuit board portion (12).

## Patentansprüche

1. Verfahren zum Herstellen einer Trägerstruktur (10) für Beleuchtungsvorrichtungen, wobei die Trägerstruktur beinhaltet:
- einen Leiterplattenabschnitt (12) mit einer vorderen Oberfläche (12a) zum Montieren von zumindest einer elektrisch betriebenen Lichtstrahlungsquelle (L), wobei der Leiterplattenabschnitt (12) elektrisch leitende Leitungen (16) aufweist, die auf die vordere Oberfläche (12a) des Leiterplattenabschnitts (12) zum elektrisch Betreiben der zumindest einen Lichtstrahlungsquelle (L) gedruckt sind, und
- einen Wärmesenkenabschnitt (14), der mit der Rückfläche des Leiterplattenabschnitts (12) gekoppelt ist, um Wärme, die durch die zumindest eine Lichtstrahlungsquelle (L) erzeugt wird, abzuleiten, wobei:
- der Wärmesenkenabschnitt (14) ein thermisch leitendes thermoplastisches Material beinhaltet,
- der Leiterplattenabschnitt (12) und der Wärmesenkenabschnitt (14) zusammen geformt sind und ohne die thermischen Schnittstellen dazwischen verbunden sind durch
- Überformen des Wärmesenkenabschnitts (14) auf den Leiterplattenabschnitt (12), oder
- Formen des Wärmesenkenabschnitts (14) und gemeinsam Formen des gedruckten Leiterplattenabschnitts (12) mit dem Wärmesenkenabschnitt (14), und wobei
- die elektrisch leitenden Leitungen (16) auf die vordere Oberfläche (12a) des Leiterplattenabschnitts (12) gedruckt werden, nachdem er mit dem Wärmesenkenabschnitt (14) gekoppelt wurde.

2. Verfahren nach Anspruch 1, wobei die elektrisch leitenden Leitungen (16) auf die vordere Oberfläche (12a) des Leiterplattenabschnitts (12) durch Siebdruck oder Tampondruck gedruckt werden.

3. Trägerstruktur nach Anspruch 1 oder Anspruch 2, wobei zumindest ein Teil des Leiterplattenabschnitts (12) zum Aufnehmen der zumindest einen elektrisch betriebenen Lichtstrahlungsquelle (L), die darauf montiert ist, mit dem Wärmesenkenabschnitt (14) ohne thermische Schnittstellen dazwischen verbunden ist.

4. Verfahren nach Anspruch 1 oder Anspruch 2, wobei der gesamte Leiterplattenabschnitt (12) mit dem Wärmesenkenabschnitt (14) ohne thermische Schnittstellen dazwischen verbunden ist.

5. Verfahren nach irgendeinem der vorhergehenden Ansprüche, wobei der Leiterplattenabschnitt (12) eine gedruckte Leiterplatte mit einem metallischen Kern ist.

6. Verfahren nach irgendeinem der vorhergehenden Ansprüche, wobei der Leiterplattenabschnitt (12) ein thermisch leitendes Kunststoffmaterial beinhaltet.

7. Verfahren nach irgendeinem der vorhergehenden Ansprüche, einschließlich mechanischer Formationen (18), um eine Kompressionskraft von dem Leiterplattenabschnitt (12) auf den Wärmesenkenabschnitt (14) zu erzeugen.

8. Verfahren nach irgendeinem der vorhergehenden Ansprüche, wobei der Leiterplattenabschnitt (12) und der Wärmesenkenabschnitt (14) ein gleiches Material beinhalten.

9. Verfahren nach irgendeinem der vorhergehenden Ansprüche, wobei der Leiterplattenabschnitt (12) und der Wärmesenkenabschnitt (14) aus einem Stück sind.

10. Verfahren nach irgendeinem der vorhergehenden Ansprüche, einschließlich eines Bereitstellens von zumindest einer elektrisch betriebenen Lichtstrahlungsquelle (L) auf der vorderen Oberfläche (12a) des Leiterplattenabschnitts (12) in elektrischem Kontakt mit den elektrisch leitenden Leitungen (16), um dadurch elektrisch betrieben zu werden.

11. Verfahren nach Anspruch 10, wobei das Verfahren ein Löten, ein Kleben oder ein Drucken der zumindest einen elektrisch betriebenen Lichtstrahlungsquelle (L) auf die vordere Oberfläche (12a) des Leiterplattenabschnitts (12) umfasst.

## Revendications

1. Un procédé de production d'une structure support (10) pour des dispositifs d'éclairage,
la structure support comprenant :
- une partie de carte de circuit (12) avec une surface frontale (12a) pour le montage d'au moins une source de rayonnement lumineux alimentée électriquement (L), la partie de carte de circuit (12) possédant des lignes électriquement conductrices (16) imprimées sur ladite surface frontale (12a) de la partie de carte de circuit (12) pour l'alimentation électrique de ladite au moins une source de rayonnement lumineux (L), et
- une partie de drain thermique (14) couplée à la face dorsale de la partie de carte de circuit (12) pour dissiper la chaleur produite par ladite au moins une source de rayonnement lumineux (L), dans lequel :
- la partie de drain thermique (14) comprend un matériau thermoplastique thermiquement conducteur,
- la partie de carte de circuit (12) et la partie de drain thermique (14) sont moulées ensemble et liées en l'absence d'interfaces thermiques entre elles par
- surmoulage de la partie de drain thermique (14) sur la partie de carte de circuit (12), ou
- moulage de la partie de drain thermique (14) et comoulage de la partie de carte de circuit imprimé (12) avec la partie de drain thermique (14),
et dans lequel
- les lignes électriquement conductrices (16) sont imprimées sur ladite surface frontale (12a) de la partie de carte de circuit (12) après qu'elle a été couplée à la partie de drain thermique (14).

2. Le procédé de la revendication 1, dans lequel les lignes électriquement conductrices (16) sont imprimées sur ladite surface frontale (12a) de la partie de carte de circuit (12) par sérigraphie ou par impression au tampon.

3. Le procédé de la revendication 1 ou de la revendication 2, dans lequel au moins une partie de la partie de carte de circuit (12) destinée à recevoir ladite au moins une source de rayonnement lumineux électriquement alimentée (L) montée dessus est liée à la partie de drain thermique (14) en l'absence d'interfaces thermiques entre les deux.

4. Le procédé de la revendication 1 ou de la revendication 2, dans lequel la totalité de la partie de carte de circuit (12) est liée à la partie de drain thermique (14) en l'absence d'interfaces thermiques entre elles.

5. Le procédé de l'une des revendications précédentes, dans lequel la partie de carte de circuit (12) est une carte de circuit imprimé à noyau métallique.

6. Le procédé de l'une des revendications précédentes, dans lequel la partie de carte de circuit (12) comprend un matériau plastique thermiquement conducteur.

7. Le procédé de l'une des revendications précédentes, comprenant des formations mécaniques (18) destinées à produire une force de compression de la partie de carte de circuit (12) vers la partie de drain thermique (14).

8. Le procédé de l'une des revendications précédentes, dans lequel ladite partie de carte de circuit (12) et ladite partie de drain thermique (14) comprennent un matériau qui est le même.

9. Le procédé de l'une des revendications précédentes, dans lequel ladite partie de carte de circuit (12) et ladite partie de drain thermique (14) sont d'une seule pièce.

10. Un procédé selon l'une des revendications précédentes, comprenant la mise en place d'au moins une source de rayonnement lumineux électriquement alimentée (L) sur ladite surface frontale (12a) de ladite partie de carte de circuit (12) en contact électrique avec lesdites lignes électriquement conductrices (16) afin de pouvoir être électriquement alimentée par ces dernières.

11. Le procédé de la revendication 10, comprenant le soudage, le collage ou l'impression de ladite source de rayonnement lumineux électriquement alimentée (L) sur ladite surface frontale (12a) de ladite partie de carte de circuit (12).
